# EUROPÄISCHE PATENTSCHRIFT

(11) **EP 0 698 290 B1**
(45) Veröffentlichungstag und Bekanntmachung des Hinweises auf die Patenterteilung: **03.03.1999**
(21) Anmeldenummer: 94913483.7
(22) Anmeldetag: 02.05.1994
(51) Int. Cl.: H01L 23/373, H01L 23/482

(54) **LEISTUNGSHALBLEITERBAUELEMENT MIT PUFFERSCHICHT**
POWER SEMICONDUCTOR DEVICE WITH STRESS BUFFER LAYER
COMPOSANT SEMI-CONDUCTEUR DE PUISSANCE COMPORTANT UNE COUCHE TAMPON

(30) Priorität: 07.05.1993 DE 4315272
(43) Veröffentlichungstag der Anmeldung: 28.02.1996
(73) Patentinhaber: SIEMENS AKTIENGESELLSCHAFT, 80333 München (DE)
(72) Erfinder: SCHWARZBAUER, Herbert, D-81373 München (DE)
(86) Internationale Anmeldenummer: DE9400483
(87) Internationale Veröffentlichungsnummer: WO9427319

(56) Entgegenhaltungen:
- EP-A- 0 139 205
- EP-A- 0 194 475
- DE-A- 3 414 065

## Beschreibung

Leistungshalbleiterbauelemente, bei denen Halbleiterchips über druckgesinterte Silberpulverschichten mit Keramiksubstraten verbunden sind, sind beispielsweise aus der europäischen Patentschrift mit der Veröffentlichungsnummer 0 242 626 B1 oder aus der deutschen Offenlegungsschrift DE 34 14 065 A1 bekannt.

Solche Niedertemperaturverbindungstechniken, bei denen beispielsweise Silberpulverschichten verwendet werden, können bei Leistungshalbleiterbauelementen auch zur Verbindung von Keramiksubstraten mit metallischen Bodenplatten Verwendung finden. Die wechselnde Temperatur infolge der abzuführenden Verlustleistung führt jedoch gerade hier aufgrund der stark unterschiedlichen Wärmeausdehnungskoeffizienten zu vorzeitiger Materialermüdung und Rißbildung, da die in der Niedertemperaturverbindungstechnik üblicherweise verwendeten Schichten, wie beispielsweise die gesinterten Silberpulverschichten, zwar eine wesentlich höhere Wärmeleitfähigkeit aufweisen als beispielsweise Verbindungen mit Weichloten auf Blei-Zinn-Basis, aber die erzielten Verbindungen im Gegensatz dazu nicht plastisch verformbar sind.

Aus der europäischen Anmeldeschrift mit der Veröffentlichungsnummer 0 139 205 ist eine Wärmedehnungsanpassung zwischen einer Isolierschicht und einem Metallsubstrat bekannt, bei der eine aus Teilschichten, beispielsweise aus Aluminium oder Kupfer, bestehende Haftschicht vorgesehen ist, wobei den Teilschichten zunehmend beispielsweise Aluminiumoxid oder andere Oxide beigefügt sind. Nachteilig ist hierbei jedoch der erhöhte elektrische Widerstand und der erhöhte technische Aufwand.

Die der Erfindung zugrundeliegende Aufgabe liegt nun darin, ein Leistungshalbleiterbauelement anzugeben, bei dem der Vorteil einer hohen Wärmeleitfähigkeit zwischen dem Keramiksubstrat und der metallischen Bodenplatte gewährleistet ist und der Nachteil der vorzeitigen Materialermüdung und Rißbildung vermieden wird.

Diese Aufgabe wird erfindungsgemäß durch die im Patentanspruch 1 angegebenen Merkmale gelöst.

Der Patentanspruch 2 betrifft eine bevorzugte Ausgestaltung der Erfindung.

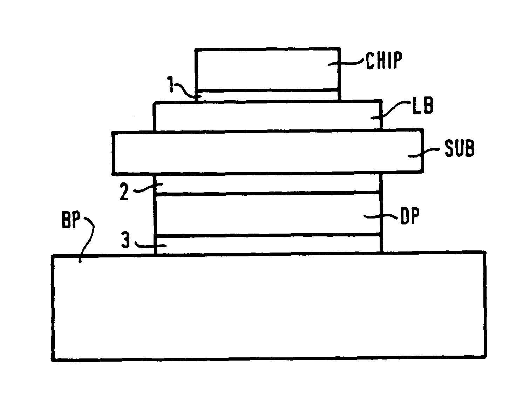

Die Erfindung wird nachfolgend anhand der Zeichnung näher erläutert.

In der Zeichnung ist eine Seitenansicht eines erfindungsgemäßen Leistungshalbleiterbauelementes dargestellt. Das erfindungsgemäße Leistungshalbleiterbauelement besteht dabei der Reihe nach aus einem Halbleiterchip CHIP, einer Verbindungsschicht 1, Leiterbahnen LB, einem Keramiksubstrat SUB, einer Verbindungsschicht 2, einer Pufferschicht aus einem Material mit niedriger Fließgrenze, einer weiteren Verbindungsschicht 3 und einer metallischen Bodenplatte BP.

Der Halbleiterchip CHIP besteht typischerweise aus dotiertem Silizium und die Leiterbahnen LB, die zum Beispiel aus Kupfer bestehen, sind typischerweise auf das Keramiksubstrat SUB, das beispielsweise aus Aluminiumoxid besteht, aufgebracht, wobei es sich hier in der Regel um sogenannte DCB-Substrate (direct copper bonding substrates) handelt, die im Handel erhältlich sind. Die Bodenplatte BP besteht beispielsweise aus Kupfer. Die Verbindungsschichten 2 und 3 und in der Regel auch die Verbindungsschicht 1 bestehen vorzugsweise aus gesintertem Silberpulver und die Schichtdicke beträgt ca. 10 µm. Die Pufferschicht besteht typischerweise aus weitgehend reinem Aluminium mit typischerweise mehr als 99 Prozent Al-Anteil, das eine niedrige Fließgrenze von ca. bis 20 N/mm² besitzt, wobei die Schichtdicke der Pufferschicht ca. 50 bis 200 µm beträgt.

Als Material für die Pufferschicht sind neben Aluminium auch andere Metalle mit niedriger Fließgrenze und hoher Wärmeleitfähigkeit, wie zum Beispiel Kupfer oder Silber, anwendbar.

Wegen der sehr unterschiedlichen Wärmeausdehnungskoeffizienten kommt es insbesondere zwischen dem Keramiksubstrat SUB und der Bodenplatte BP bei Temperaturwechseln zu mechanischen Spannungen, wenn keine Pufferschicht DP vorgesehen ist, da die Scherfestigkeit der aus dem Keramiksubstrat SUB, der Verbindungsschicht 2 und 3 und der Bodenplatten BP bestehenden Verbindung sehr hoch ist. Aufgrund der thermomechanischen Spannungen entstehen ohne Pufferschicht vorzeitige Materialermüdungserscheingungen und Rißbildungen vor allem in den Verbindungsschichten 2 und 3.

Durch die Verwendung einer Pufferschicht (stress buffer layer), beispielsweise aus weichem Reinaluminium, werden diese Spannungen abgebaut und die oben erwähnten Nachteile dadurch vermieden und trotzdem ein sehr guter Wärmewiderstand gewährleistet.

## Patentansprüche

1. Leistungshalbleiterbauelement,
bei dem auf einer Seite eines Keramiksubstrats (SUB) Leiterbahnen (LB) aufgebracht sind, die mit Hilfe einer ersten Verbindungsschicht (1) mit mindestens einem Halbleiterchip (CHIP) mechanisch verbunden sind,
bei dem auf der anderen Seite des Keramiksubstrats eine Dehnungspufferschicht (DP) aus einem Metall aus der Gruppe Kupfer, Silber oder Reinaluminium mit einem Aluminiumanteil von mehr als 99 Prozent mit Hilfe einer zweiten Verbindungsschicht (2) aufgebracht ist und die Pufferschicht über eine dritte Verbindungsschicht (3) mit einer metallischen Bodenplatte (BP) verbunden ist und
bei dem die Verbindungsschichten (1, 2, 3) aus gesintertem Silberpulver bestehen.

2. Leistungshalbleiterbauelement nach Anspruch 1,
bei dem die Dehnungspufferschicht (DP) eine Dicke von 50 bis 200 µm aufweist.

## Claims

1. Power semiconductor component,
in which conductor tracks (LB) are applied to one side of a ceramic substrate (SUB) and are mechanically connected to at least one semiconductor chip (CHIP) with the aid of a first connecting layer (1),
in which a stress buffer layer (DP) made of a metal from the group consisting of copper, silver or pure aluminium with an aluminium content of more than 99 per cent is applied to the other side of the ceramic substrate with the aid of a second connecting layer (2), and the buffer layer is connected to a metallic baseplate (BP) via a third connecting layer (3), and
in which the connecting layers (1, 2, 3) consist of sintered silver powder.

2. Power semiconductor component according to Claim 1,
in which the stress buffer layer (DP) has a thickness of 50 to 200 µm.

## Revendications

1. Composant semi-conducteur de puissance,
dans lequel est appliqué, d'un côté d'un substrat céramique (SUB), des circuits conducteurs (LB) qui sont reliés mécaniquement à au moins une puce semiconductrice (CHIP) au moyen d'une première couche de liaison (1),
dans lequel, de l'autre côté du substrat céramique, est appliqué au moyen d'une deuxième couche de liaison (2) une couche tampon de dilatation (DP) réalisée en un métal du groupe cuivre, argent ou aluminium pur avec une part d'aluminium supérieure à 99 pour cent, et où la couche tampon est reliée par une troisième couche de liaison (3) à une plaque de fond métallique (BP), et
dans lequel les couches de liaison (1, 2, 3) sont en poudre d'argent frittée.

2. Composant semi-conducteur de puissance selon la revendication 1,
dans lequel la couche tampon de dilatation ( (DP) a une épaisseur de 50 à 200 µm.
